Europäisches Patentamt

European Patent Office

Office européen des brevets

(11) Publication number: **0 473 144 A2**

# EUROPEAN PATENT APPLICATION

(21) Application number: **91114472.3**

(22) Date of filing: **28.08.91**

(51) Int. Cl.5: **H01L 23/522**

(30) Priority: **28.08.90 JP 225768/90**

(43) Date of publication of application:
**04.03.92 Bulletin 92/10**

(84) Designated Contracting States:
**DE FR GB**

(71) Applicant: **NEC CORPORATION**
**7-1, Shiba 5-chome Minato-ku**
**Tokyo 108-01(JP)**

(72) Inventor: **Okumura, Koichiro**
**c/o NEC Corporation, 7-1, Shiba 5-chome**
**Minato-ku, Tokyo(JP)**

(74) Representative: **Glawe, Delfs, Moll & Partner**
**Patentanwälte**
**Postfach 26 01 62 Liebherrstrasse 20**
**W-8000 München 26(DE)**

(54) Semiconductor integrated circuit comprising interconnections.

(57) A semiconductor integrated circuit comprises large and small signal interconnections. The small signal interconnections are arranged in group structure to take a position which is higher in layer structure than the large signal interconnections. For this structure, shielding electrodes which are necessary in a conventional semiconductor integrated circuit becomes unnecessary.

## FIG.5

## FIELD OF THE INVENTION

The invention relates to a semiconductor integrated circuit, and more particularly to, a semiconductor integrated circuit including Complementary Metal Oxide Semiconductor (defined "CMOS" hereinafter) circuit and Emitter Coupled Logic (defined "ECL" hereinafter) circuit operating with signals having different amplitudes.

## BACKGROUND OF THE INVENTION

A sense amplifier circuit for a memory integrated circuit includes small signal interconnections for signals having a small amplitude and large signal interconnections for signals having a large amplitude. In such a semiconductor integrated circuit including these small and large signal interconnections, noise is generated on the small signal interconnections due to capacitive coupling between the small and large signal interconnections, when a signal is changed on the large signal interconnections, so that incorrect operation may occur in a small amplitude signal circuit. Ordinarily, a distance between small and large signal interconnections is expanded to avoid the generation of noise.

Otherwise, a semiconductor integrated circuit having shieldind electrodes provided on left and right sides, and upper and lower sides of small signal interconnections has been proposed for the same purpose. In the integrated circuit, the shielding electrodes are connected to a fixed potential for the shielding of noise, so that incorrect operation of a small amplitude signal circuit such as a sense amplifier circuit, etc. can be avoided.

This is an effective structure of a circuit such as a sense amplifier circuit having a small number of small signal interconnections. In a circuit having considerable number and length of small signal interconnections, however, it is required to arrange shielding electrodes occupying a large area therein, so that the layout of interconnections becomes very complicated in the circuit, and a density of interconnections is lowered.

In these days, there has been widely used the so-called sectional design method, by which the design of a semiconductor integrated circuit chip is completed by interconnecting a plurality of macrocells, each of which is designed with a circuit pattern and a layout pattern inherent to a function assigned thereto, because it is difficult to design a whole chip of a semiconductor integrated circuit totally in accordance with the increase of an integration degree.

In a semiconductor integrated circuit chip which is designed by the sectional design method, each macro-cell comprises a number of devices for composing CMOS circuit, wherein the devices are connected to provide a specified function by internal macro-cell to macro-cell interconnections of plural layers.

In this semiconductor integrated circuit, however, a length of interconnections for connecting the macro-cells becomes very long to result in the delay of signal propagation among the macro-cells. For the purpose of avoiding the signal delay, a Bipolar CMOS (defined "BiCMOS" hereinafter) circuit is provided in the macro-cell to drive interconnections.

Under these situations, there has been begun the study in which a BiCMOS circuit is replaced to enhance the improvement of the signal delay by an ECL circuit having a higher load capacitive driving power, because the miniaturization of devices for the large scale integration and the provision of multi-functions are still continued, so that the number of macro-cells is increased in a semiconductor integrated circuit, and paths of interconnections are complicated among macro-cells to increase a length of interconnections. Another reason for using the ECL circuit is that a high speed operation is much more required in a semiconductor integrated circuit.

## SUMMARY OF THE INVENTION

Accordingly, it is an object of the invention to provide a semiconductor integrated circuit in which incorrect operation of a small amplitude signal circuit is precisely avoided.

It is a further object of the invention to provide a semiconductor integrated circuit in which the design of small signal interconnections becomes easy, even if the number of the small signal interconnections is increased.

It is a still further object of the invention to provide a semiconductor integrated circuit in which the degree of integration is increased.

According to the invention, a semiconductor integrated circuit, comprises:

small signal interconnections for a small amplitude signal;

large signal interconnections for a large amplitude signals; wherein:

the improvement is characterized in that the small signal interconnections are arranged in group structure to provide at least one upper interconnection layer which is positioned over the large signal interconnections providing at least one lower interconnection layer.

## BRIEF DESCRIPTION OF THE DRAWINGS

This invention will be explained in more detail in conjunction with appended drawings, wherein:

Fig. 1 is a schematic cross-sectional view showing a conventional semiconductor integrated circuit;

Fig. 2 is a schematic plan view showing a semiconductor integrated circuit which is designed by the sectional design method;

Fig. 3 is a schematic plan view showing macro-cells connected by interconnections on which signals of an ECL level are propagated;

Figs. 4 and 5 are schematic cross-sectional views showing semiconductor integrated circuits of first and second preferred embodiments according to the invention, respectively;

Fig. 6A is a schematic plan view showing a semiconductor integrated circuit of a third preferred embodiment according to the invention, and Fig. 6B is a cross-sectional view cut along line VI-VI in Fig. 6A; Figs. 7 to 10 are schematic cross-sectional

views showing semiconductor integrated circuits of fourth to seventh preferred embodiments according to the invention, respectively;

Fig. 11A is a schematic plan view showing a semiconductor integrated circuit of a eighth preferred embodiment according to the invention, and Fig. 11B is a cross-sectional view cut along line XI-XI in Fig. 11A; and

Fig. 12A is a schematic plan view showing a semiconductor integrated circuit of a ninth preferred embodiment according to the invention, and Figs. 12B and 12C are cross-sectional views cut along lines XIIB-XIIB and XIIC-XIIC in Fig. 12A.

## DESCRIPTION OF THE PREFERRED EMBODIMENTS

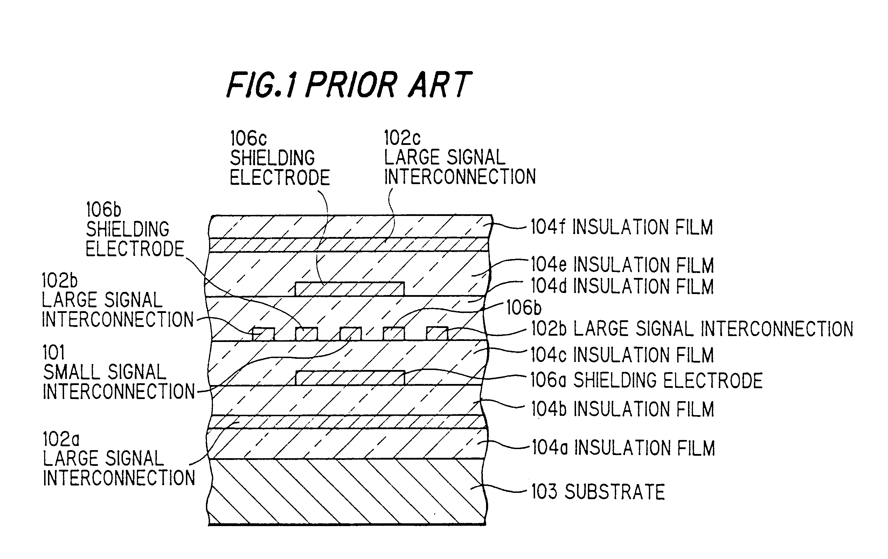

Before explaining a semiconductor integrated circuit of a preferred embodiment according to the invention, the aforementioned conventional semiconductor integrated circuit will be explained in Fig. 1.

The conventional semiconductor integrated circuit comprises a semiconductor substrate 103, insulation films 104a, 104b, 104c, 104d, 104e and 104f grown successively on the semiconductor substrate 103, a small signal interconnection 101 provided on the insulation film 104c, large signal interconnections 102a, 102b and 102c provided on the insulation films 104a, 104c and 104e, respectively, and shielding electrodes 106a, 106b and 106c provided between the small signal interconnection 101 and the large signal interconnection 102a, between the small signal interconnection 101 and each of the large signal interconnections 102b of the same layer, and between the small signal interconnection 101 and the large signal interconnection 102c, respectively.

In this semiconductor integrated circuit, noise generated by the change of signals flowing through the large signal interconnections 102a, 102b and 102c is shielded by the shielding electrodes 106a, 106b and 106c, so that the change of a signal flowing through the small signal interconnection is suppressed to avoid incorrect operation of a small amplitude signal circuit such as a sense amplifier circuit.

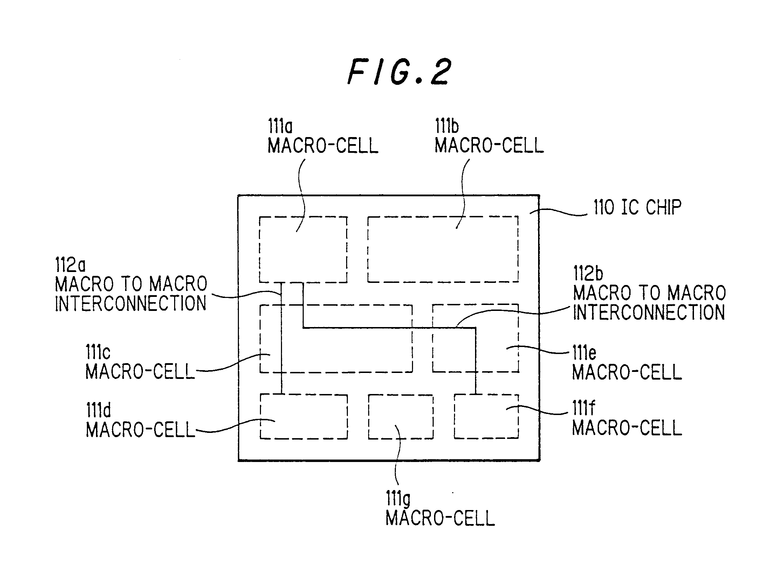

Fig. 2 shows the aforementioned semiconductor integrated circuit chip which is designed by the sectional design method. This semiconductor integrated circuit chip 110 comprises macro-cells 111a to 111g which are connected by interconnections (not shown), among which the macro-cells 111a and 111d are connected by an interconnection 112a having a plurality of signal lines passing over the macro-cell 111c, and the macro-cells 111a and 111f are connected by an interconnection 112b similarly having a plurality of signal lines passing over the macro-cells 111c and 111b.

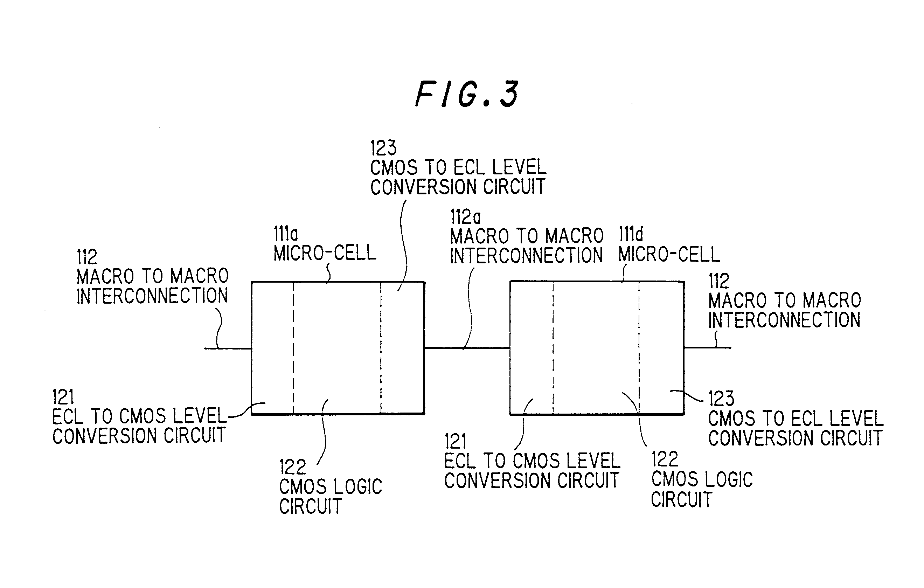

Fig. 3 shows a structure of the macro-cells 111a and 111d which are connected by the interconnection 112a. Each of the macro-cells 111a and 111d comprises an ECL to CMOS level conversion circuit 121 a CMOS logic circuit 122 and a CMOS to ECL level conversion circuit 123, and an ECL level signal of ordinarily 0.5 V amplitude flows through the interconnection 112a, and interconnections 112 connected to the ECL to CMOS level conversion circuit 121 of the macro-cell 111a and the CMOS to ECL level conversion circuit 123 of the macro-cell 111d.

In this macro-cells 111a and 111d, the ECL level signal is converted in the ECL to CMOS level conversion circuit 121 to a CMOS level signal of ordinarily 5 V amplitude which is then supplied to the CMOS logic circuit 122, in which functions such as logic arithmetics specified for the macro-cells 111a and 111d are carried out, and arithmetic results of the CMOS level are converted in the CMOS to ECL level conversion circuit 123 to an ECL level signal which is then supplied to an internal ECL circuit to the interconnections 112a and 112.

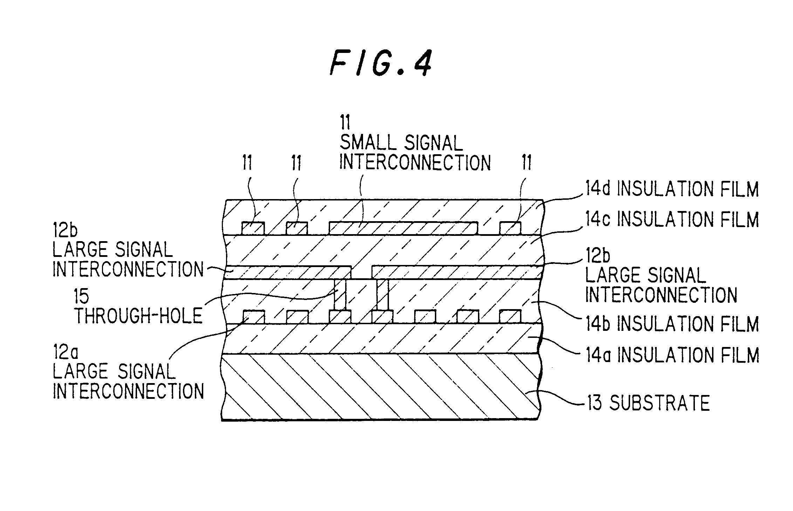

Next, a semiconductor integrated circuit of a first preferred embodiment according to the invention will be explained in Fig. 4. The semiconductor integrated circuit comprises a semiconductor substrate 13, insulation films 14a, 14b, 14c and 14d successively grown on the semiconductor substrate 13, first large signal interconnections 12a provided in parallel on the insulation film 14a and covered with the insulation film 14b, second large signal interconnections 12b provided in parallel on the insulation film 14b to be orthogonal to the direction of the first large signal interconnections 12a and covered with the insulation film 14c, and a plurality of small signal interconnections 11 provided on the insulation film 14c and covered with the insulation film 14d, wherein some of the first and second large signal interconnections 12a and 12b are connected by through-holes 15, and the connection of devices is realized in a macro-cell by use of these large signal interconnections 12a and 12b, while the small signal interconnections 11 are used for the connection with other macro-cells.

In the first preferred embodiment, it becomes unnecessary to consider the capacitive coupling relative to proximate signal interconnections in a semiconductor integrated circuit having a number of macro-cell to macro-cell interconnections of an ECL level, and to provide shielding electrodes therein, because the small signal interconnections are provided as a third layer, while the large signal interconnections are provided as first and second layers. Thus, the design of the semiconductor integrated circuit becomes simple and easy, and the integration degree becomes high.

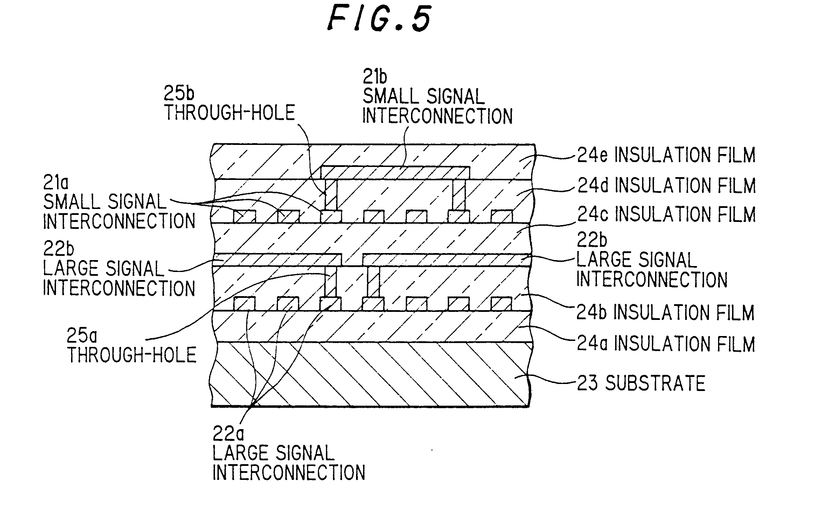

A semiconductor integrated circuit of a second preferred embodiment according to the invention will be explained in Fig. 5. The semiconductor integrated circuit comprises a semiconductor substrate 23, insulation films 24a, 24b, 24c, 24d and 24e successively grown on the semiconductor substrate 23, first large signal interconnections 22a provided in parallel on the insulation film 24a and covered with the insulation film 24b, second large signal interconnections 22b provided in parallel on the insulation film 24b to be orthogonal to the direction of the first large signal interconnections 22a and covered with the insulation film 24c, first small signal interconnections 21a provided on the insulation film 24c and covered with the insulation film 24d, and second small signal interconnections 21b provided in parallel on the insulation film 24d to be orthogonal to the direction of the first small signal interconnections 21a and covered with the insulation film 24c, wherein some of the first and second large signal interconnections 22a and 22b are connected by through-holes 25a, and the connection of devices is realized in a macro-cell by use of these large signal interconnections 22a and 22b, while some of the first and second small signal interconnections 21a and 21b are connected by through-holes 25b, and the small signal interconnections 21a and 21b are used for the connection with other macro-cells.

In the second preferred embodiment, it becomes unnecessary to consider the capacitive coupling relative to proximate signal interconnections in a semiconductor integrated circuit having a number of macro-cell to macro-cell interconnections of an ECL level, and to provide shielding electrodes therein, because the small signal interconnections are provided as third and fourth layers which are positioned above first and second layers for the large signal interconnections 22a and 22b. Even more, the small signal interconnections 21a and 21b are arranged to be orthogonal in their directions, so that the design is simpler and easier than in the first preferred embodiment, and the integration degree is much improved.

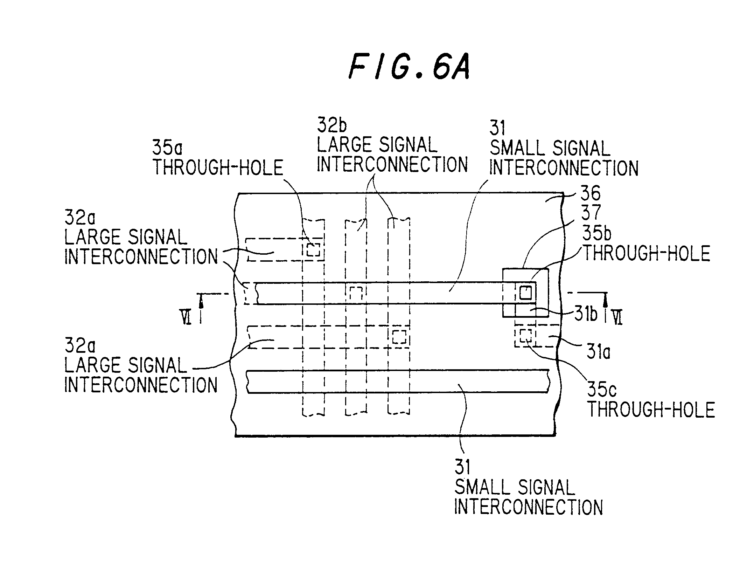

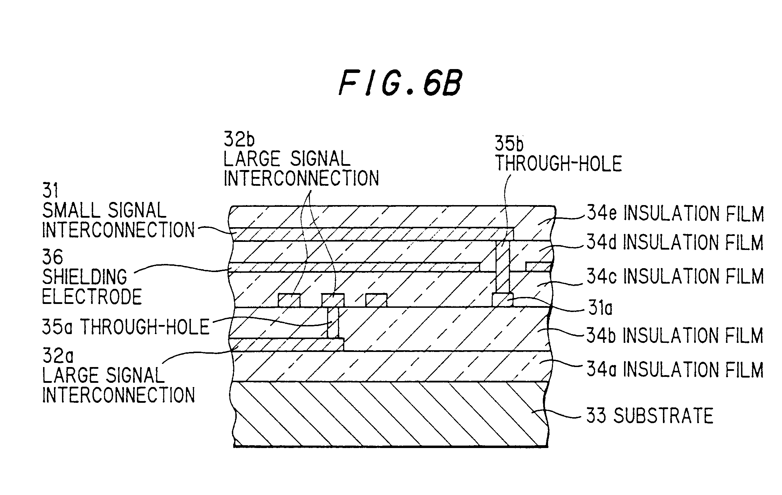

Figs. 6A and 6B show a semiconductor integrated circuit of a third preferred embodiment according to the invention. The semiconductor integrated circuit comprises a semiconductor substrate 33, insulation films 34a, 34b, 34c, 34d and 34e successively grown on the semiconductor substrate 33, first large signal interconnections 32a provided in parallel on the insulation film 34a and covered with insulation film 34b, second large signal interconnections 32b provided in parallel on the insulation film 34b to be orthogonal to the direction of the first large signal interconnections 32a, covered with the insulation film 34c, and connected through a through-hole 35a to the first large signal interconnections 32a, a shielding electrode 36 provided on the insulation film 34c and covered with the insulation film 34d to have an area corresponding to that of the substrate 33, and small signal interconnections 31 provided on the insulation film 34d and covered with the insulation film 34e to be connected through a through-hole 35b grown selectively in a window 37 of the shielding elecrode 36 to a short small signal interconnection 31b which is connected through a through-hole 35 to a short small signal interconnection 31a for an output of a small amplitude signal circuit. In this semiconductor integrated circuit, devices are connected in a macro-cell by the first and second large signal interconnections 32a and 32b, and the macro-cell is connected to other macro-cells by the small signal interconnections 31.

In the third preferred embodiment, the small signal interconnections 31 of the upper layer are completely shielded from the first and second large signal interconnections 32a and 32b of the lower layers by the shielding layer 36, so that incorrect operation of the small amplitude signal circuit is precisely avoided. In addition, a large capacitance is formed between the substrate 33 and the shielding electrode 36, because the shielding electrode 36 has an area approximately equal to that of the substrate 33, so that the shielding effect is realized therein, even if the shielding electrode 36 is not fixed to a potential such as a ground potential. For this reason, an additional step for the fixing of potential becomes unnecessary in design and manufacture of the semiconductor integrated circuit. Consequently, even in a semiconductor integrated circuit having a large number of macro-cell to macro-cell interconnections of the ECL level, it becomes unnecessary to consider capacitive couplings with proximate interconnections and with the large signal interconnections of the lower layers, so that the design is simple and easy, and the integration degree is high.

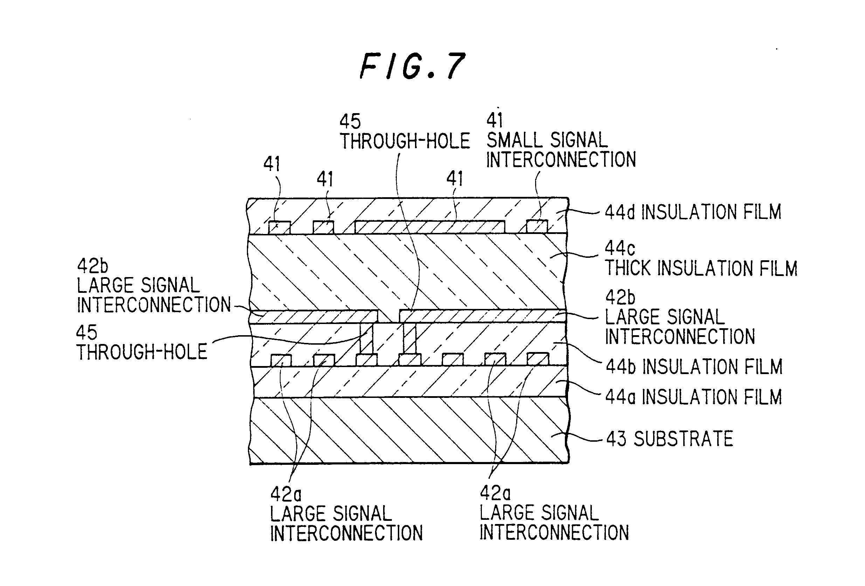

Fig. 7 shows a semiconductor integrated circuit of a fourth preferred embodiment according to the invention. The semiconductor integrated circuit comprises a semiconductor substrate 43, insulation films 44a, 44b, 44c and 44d (among which the insulation film 44c is thicker) successively grown on the substrate 43, first large signal interconnections 42a provided in parallel on the insulation film 44a and covered with the insulation film 44b, second large signal interconnections 42b provided in parallel on the insulation film 44b and covered with the thick insulation film 44c to be orthogonal to the direction of the first large signal interconnections 42a and connected through through-holes 45 thereto, and small signal interconnections 41 provided on the thick insulation film 44c and covered with the insulation film 44d. In this semiconductor integrated circuit, devices are connected in a macro-cell by the first and second large signal interconnections 42a and 42b, and the small signal interconnections 41 are used for macro-cell to macro-cell interconnections.

In this fourth preferred embodiment, coupling capacitances become small between each of the small signal interconnections 41 and each of the first and second large signal interconnections 42a and 42b, because the insulation film 44c is thick, so that incorrect operation of a small amplitude signal circuit is avoided. This advantage is obtained without increasing the number of manufacturing steps for the semiconductor integrated circuit as compared to the conventional method. Similarly, the same advantages as in the first to third preferred embodiments are obtained.

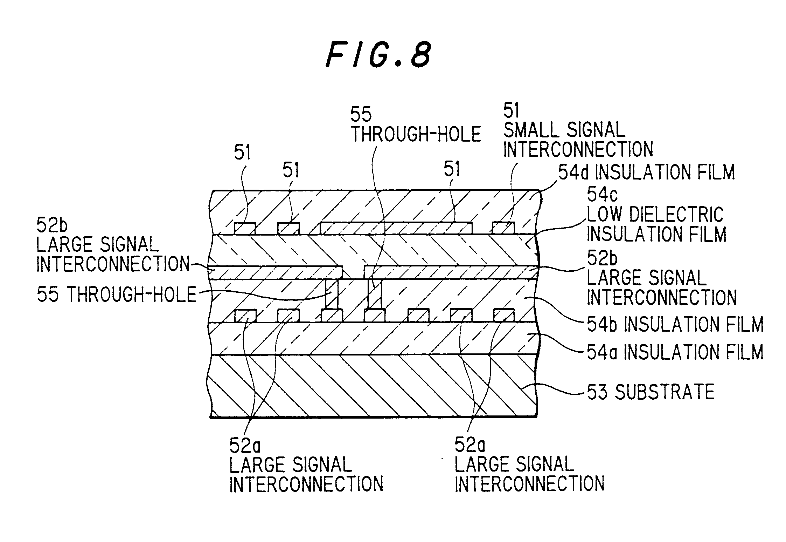

Fig. 8 shows a semiconductor integrated circuit of a fifth preferred embodiment according to the invention. The semiconductor integrated circuit comprises a semiconductor substrate 53, insulation films 54a and 54b of $SiO_2$, an insulation film 54c of polyimide and an insulation film 54d of $SiO_2$ successively grown on the substrate 53, first and second large signal interconnections 52a and 52b, some of which are connected by through-holes 55, provided in parallel on the insulation films 54a and 54b and covered with the insulation films 54b and 54c, respectively, to be orthogonal in directions to each other, and small signal interconnections 51 provided on the insulation film 54c and covered with the insulation film 54d, wherein the first and second large signal interconnections 52a and 52b are used for the connection of devices in a macro-cell, and the small signal interconnections 51 are used for the connection of macro-cell to macro-cell.

In this fifth preferred embodiment, the insulation film 54c is of polyimide such as siloxane modified polyimide having a dielectric constant of 3 to 3.5 which is lower than that of the $SiO_2$ insulation films 54a, 54b and 54d ranging from 3.8 to 4, so that capacitive couplings are small between each of the small signal interconnections 51 and each of the fist and second large signal interconnections 54a and 54b. As a result, incorrect operation of a small signal amplitude circuit is avoided. Similarly, the same advantages as in the first to fourth preferred embodiments are obtained.

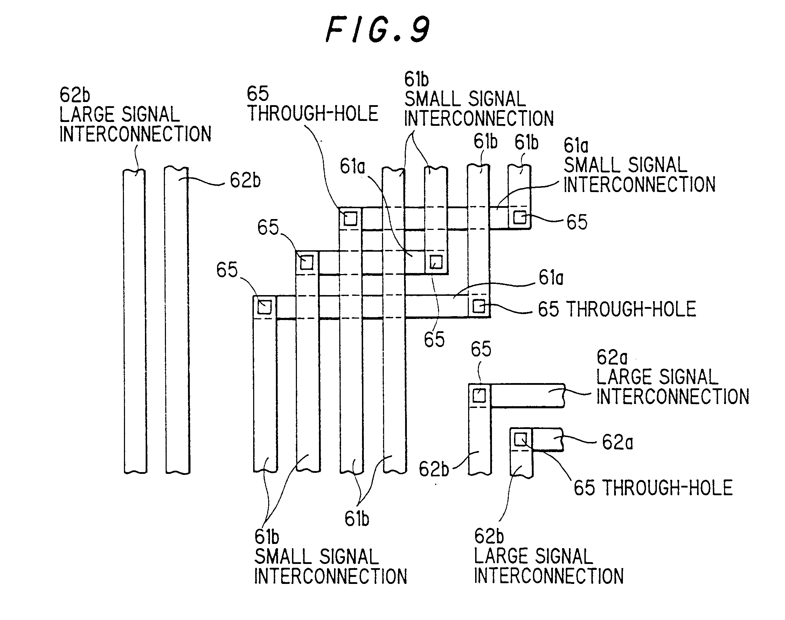

Fig. 9 shows a semiconductor integrated circuit of a sixth preferred embodiment according to the invention. The semiconductor integrated circuit comprises first and second large signal interconnections (not shown) insulated on a semiconductor substrate (not shown) by insulation films (not shown), the structure of which is similar to those of the first to fifth preferred embodiment. The semiconductor integrated circuit further comprises third large signal interconnections 62a and first small signal interconnections 61a provided in parallel commonly on an insulation film (not shown) for covering the second large signal interconnections to be orthogonal to the direction thereof, and fourth large signal interconnections 62b and second small signal interconnections 61b provided in parallel commonly on an insulation film (not shown) for covering the third large signal interconnections 62a and the first small signal interconnections 61a to be orthogonal to the direction thereof, and covered with an uppermost insulation film (not shown), wherein the first and second small signal interconnections 61a and 61b, and the third and fourth large signal interconnections 62a and 62, respectively, are selectively connected by through-holes 65. In this semiconductor integrated circuit, intervals between each two of the first small signal interconnections 61a and between each two of the second small signal interconnections 61b are smaller than distances from the first small signal interconnections 61a to the third large signal interconnections 62a, and from the second small signal interconnections 61b to the fourth large signal interconnections 62b.

In this sixth preferred embodiment, the first and second small signal interconnections 61a and 61b are arranged in group structure to be third and fourth interconnection layers together with the third and fourth large signal interconnections 62a and 62b, such that the third and fourth large signal interconnections 62a and 62b are apart from the first and second small signal interconnections 61a and 61b by a predetermined distance, by which coupling capacitances are small to avoid incorrect operation of a small signal amplitude circuit. For this structure, the number of devices which are connected in a macro-cell by large signal interconnections is increased, because the number of the large signal interconnections is increased. Therefore, the integration degree is further increased.

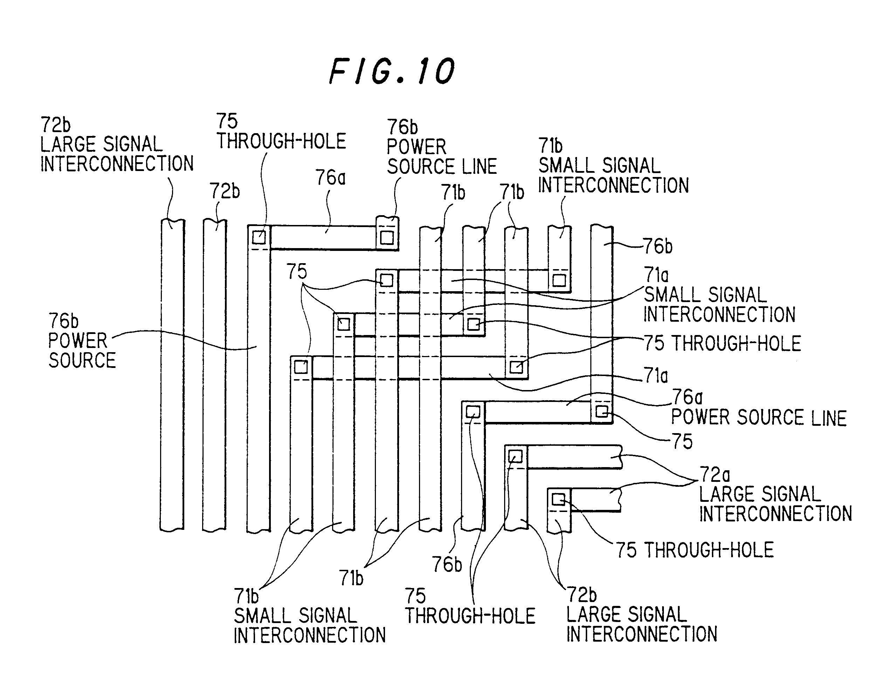

Fig. 10 shows a semiconductor integrated circuit of the seventh preferred embodiment according to the invention. The semiconductor integrated circuit is common in structure to that of the sixth preferred embodiment in that first and second small signal interconnections 71a and 71b correspond to the first and second small signal interconnections 61a and 61b, third and fourth large signal interconnections 72a and 72b correspond to the third and fourth large signal intercnnections 62a and 62, and some of through-holes 75 correspond to the through-holes 65, respectively, between Figs. 9 and 10. Additionally, the semiconductor integrated circuit comprises a power source line 76a positioned between the adjacent small and large signal interconnections 71a and 72a of the third interconnection layer, another power source line 76a positioned in parallel to the small signal interconnections 71a, and power source lines 76b connected through through-holes 75 to the power source lines 76a and positioned between the adjacent small and large signal interconnections 71b and 72b of the fourth interconnection layer.

In this seventh preferred embodiment, the power source lines 76a and 76b function as shielding electrodes, so that coupling capacitances are extremely small among the small signal interconnections 71a and 71b, and the large signal interconnections 72a and 72b. As a result, incorrect operation of a small amplitude signal circuit is more precisely avoided. As a matter of course, the advantages of the sixth preferred embodiment are similarly obtained.

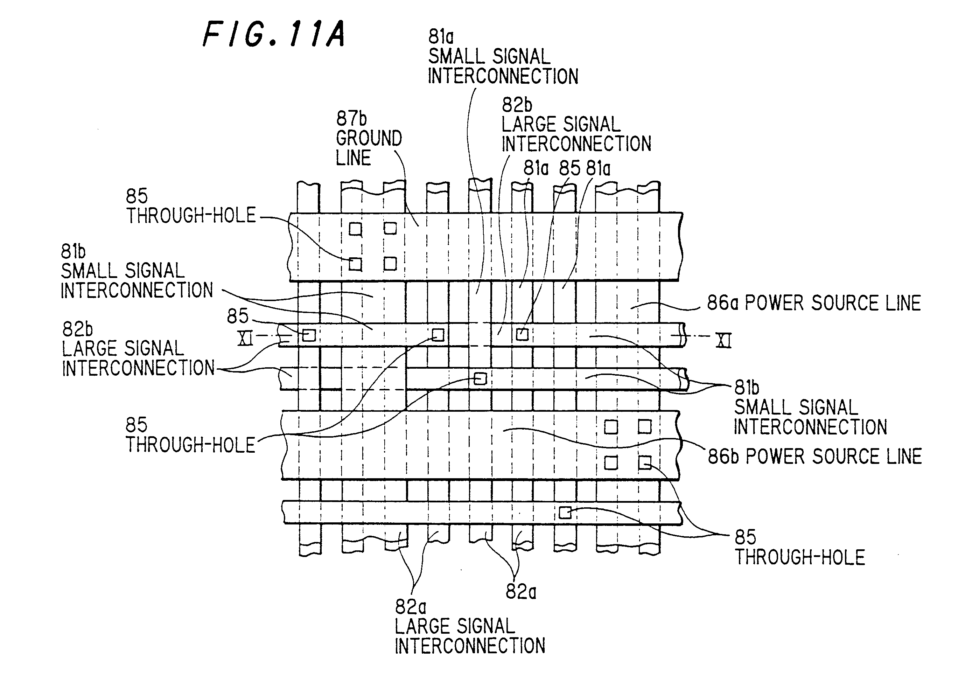

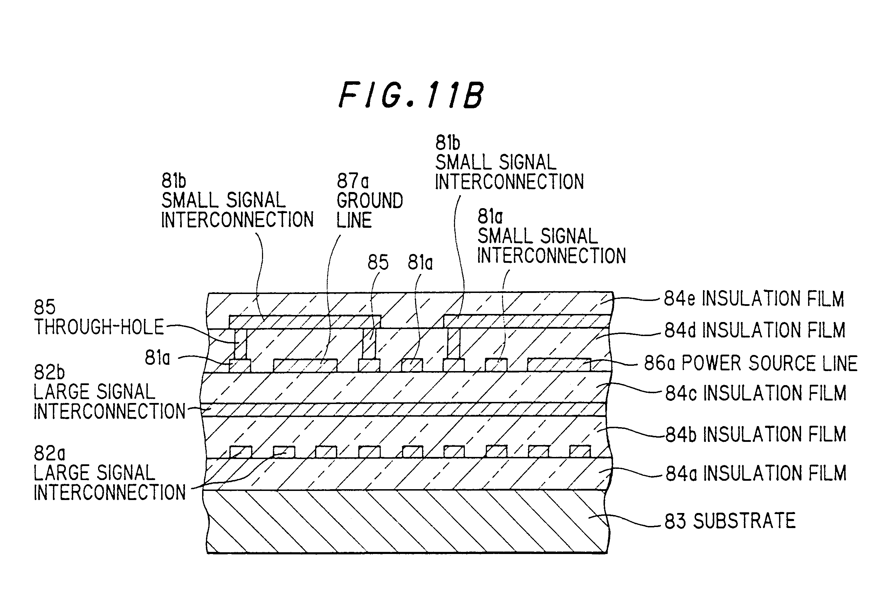

Figs. 11A and 11B show a semiconductor integrated circuit of an eighth preferred embodiment according to the invention. The semiconductor integrated circuit comprises a semiconductor substrate 83, insulation films 84a, 84b, 84c, 84d and 84e successively grown on the substrate 83, first and second large signal interconnections 82a and 82b, respectively, provided on the insulation films 84a and 84b and covered with the insulation films 84b and 84c to be orthogonal in the directions thereof to each other and connected to each other by through-holes (not shown), first and second small signal interconnections 81a and 81b, respectively, provided on the insulation films 84c and 84d and covered with the insulation films 84d and 84e to be orthogonal in the directions thereof to each other and connected to each other by through-holes 85, first and second power source lines 86a and 86b of a voltage 5 V, respectively, provided on the insulation films 84c and 84d and covered with the insulation films 84d and 84e to be orthogonal in the directions thereof and connected by through-holes 85, and first and second ground lines 87a and 87b of a voltage 0 V, respectively, provided on the insulation films 84c and 84d and covered with the insulation films 84d and 84e to be orthogonal in the directions thereof and connected by through-holes 85.

In this eighth preferred embodiment, the third and fourth interconnection layers only comprises the small signal interconnections 81a and 81b, the 5 V power supply lines 86a and 86b, and the 0 V ground lines 87a and 87b, and no large signal interconnection for causing the generation of noise, so that the design can be made without considering incorrect operation caused by coupling capacitance relative to proximate interconnections. In a semiconductor integrated circuit chip having less ECL level's interconnections of macro-cell to macro-cell, especially, the third and fourth interconnection layers can be effectively used for the power source and ground lines, so that an increased interconnection density is obtained. In addition, when a number of power source lines are arranged in parallel, a resistance of the power source lines is decreased, so that a potential of the power source lines is maintained to be stable on the whole area of a semiconductor integrated circuit chip, even if a large power source current flows therethrough.

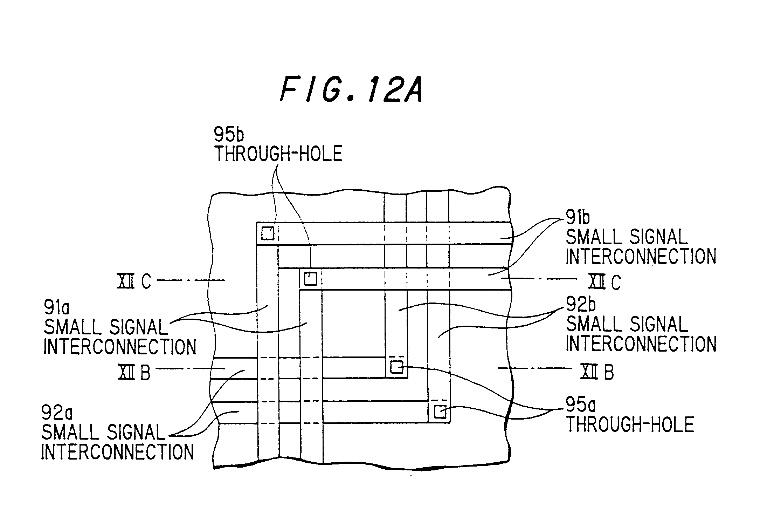

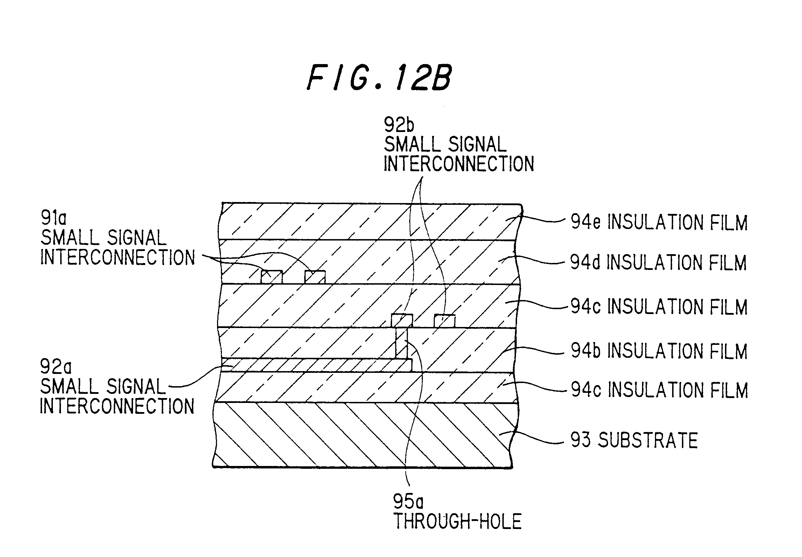

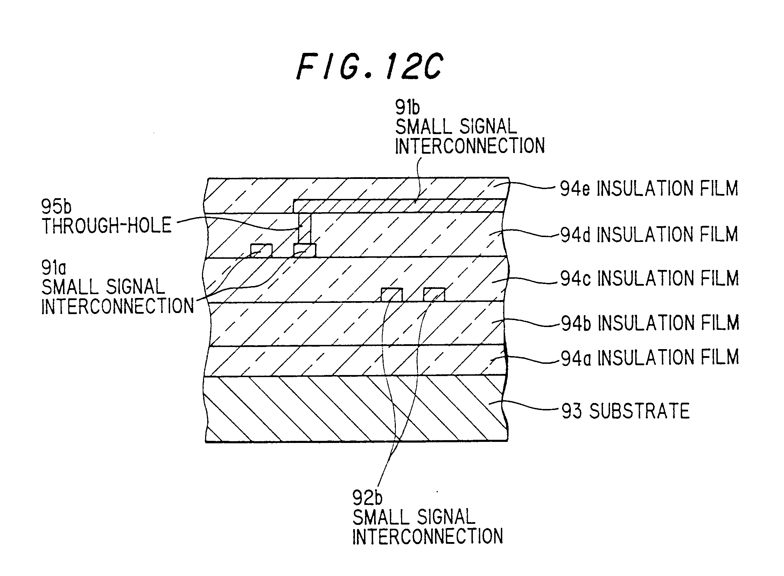

Figs. 12A to 12C show a semiconductor integrated circuit of a ninth preferred embodiment according to the invention. The semiconductor integrated circuit comprises a semiconductor substrate 93, insulation films 94a, 94b, 94c, 94d and 94e, first large signal interconnections 92a of an interconnecting pattern for a first interconnection layer provided on the insulation film 94a and covered with the insulation film 94b, second large signal interconnections 92b of an interconnecting pattern for a second interconnection layer provided on the insulation film 94b and covered with the insulation film 94c to be orthogonal in the direction thereof to the first large signal interconnections 92a and connected thereto by through-holes 95a, first small signal interconnections 91a provided on a position of the insulation film 94c, under which no second large signal interconnection 92b is provided, and covered with the insulation film 94d to be orthogonal in the direction thereof to the second large signal interconnections 92b, and second small signal interconnections 91b provided on the insulation film 94d and covered with the insulation film 94e to be orthogonal in the direction thereof to the first small signal interconnections 91a and connected thereto by through-holes 95b.

In this ninth preferred embodiment, the first large signal interconnections 92a of the first interconnection layer and the first small signal interconnections 91a of the third interconnection layer are apart from each other by a distance equal to an insulation film thickness corresponding to the difference of the first and third interconnection layers, so that coupling capacitances therebetween are small. the same structure is found between the second large and small signal interconnections 92b and 91b. For this structure, incorrect operation of a small amplitude signal circuit which is caused by the change of signals flowing through the large signal interconnections 92a and 92b is avoided.

As described in the first to ninth preferred embodiments, a semiconductor integrated circuit has a structure in which small signal interconnections are arranged in a group pattern(s) for an upper interconnection layer(s), so that noise which is caused by the change of signals flowing through large signal interconnections is suppressed to be generated on the small signal interconnections without providing shielding electrodes on the upper and lower sides of, and on the left and right sides of the small signal interconnections. Consequently, a semiconductor integrated circuit of the invention is easy to be designed and becomes high in the integration. In a semiconductor integrated circuit having a large number of small signal interconnections and a large total length of the interconnections in which the ECL level is used for an amplitude level of signals flowing through interconnections of macro-cell to macro-cell, especially, the advantages on the easiness of design and the high integration become remarkable.

Although the invention has been described with respect to specific embodiment for complete and clear disclosure, the appended claims are not to be thus limited but are to be construed as embodying all modification and alternative constructions that may occur to one skilled in the art which fairly fall within the basic teaching herein set forth.

## Claims

1. In a semiconductor integrated circuit comprising large signal interconnections for a large amplitude signal and small signal interconnections for a small amplitude signal,
   the improvement is characterized in that said small signal interconnections are arranged in group structure to provide at least one upper interconnection layer which is positioned over said large signal interconnections providing at least one lower interconnection layer.

2. In a semiconductor integrated circuit according to claim 1,
   interconnection layers are equal to or more than three in number for said large and small signal interconnections; and
   said small signal interconnections are arranged in group structure to provide an uppermost interconnection layer.

3. In a semiconductor integrated circuit according to claim 1,
   interconnection layers are equal to or more than four in number for said large and small signal interconnections; and
   said small signal interconnections are arranged in group structure to provide uppermost and secondly highest interconnection layer.

4. In a semiconductor integrated circuit according to claim 1,
   the improvement further comprises a noise shielding electrode layer including at least one noise shielding electrode to be provided between said upper and lower interconnection layers.

5. In a semiconductor integrated circuit according to claim 1,
   said upper and lower interconnection layers are insulated by an insulation layer being larger in thickness than other insulation layers provided in said upper and lower interconnection layers.

6. In a semiconductor integrated circuit according to claim 1,
   said upper and lower interconnection layers are insulated by an insulation layer being larger in dielectric constant than other insulation layers provided in said upper and lower interconnection layers.

7. In a semiconductor integrated circuit according to claim 1,
   said upper interconnection layer comprises large signal interconnections which are arranged in group structure; and an interval between said group structures for said small and large signal interconnections is larger than an interval between two adjacent interconnections of said small signal interconnections.

8. In a semiconductor integrated circuit according to claim 7,
   the improvement further comprises at least one power source line which is provided in said interval between said group structures.

9. In a semiconductor integrated circuit according to claim 1,
   said upper interconnection layer comprises at least two small signal interconnection layers which are orthogonal in directions thereof to each other; and said lower interconnection layer comprises at least two large signal interconnection layers which are orthogonal in directions thereof to each other.

## FIG.1 PRIOR ART

106c
SHIELDING
ELECTRODE

102c
LARGE SIGNAL
INTERCONNECTION

106b
SHIELDING
ELECTRODE

102b
LARGE SIGNAL
INTERCONNECTION

101
SMALL SIGNAL
INTERCONNECTION

102a
LARGE SIGNAL
INTERCONNECTION

104f INSULATION FILM

104e INSULATION FILM
104d INSULATION FILM

106b

102b LARGE SIGNAL INTERCONNECTION

104c INSULATION FILM

106a SHIELDING ELECTRODE

104b INSULATION FILM

104a INSULATION FILM

103 SUBSTRATE

EP 0 473 144 A2

FIG.2

## FIG.3

123
CMOS TO ECL LEVEL
CONVERSION CIRCUIT

112a
MACRO TO MACRO
INTERCONNECTION

111a
MICRO-CELL

111d
MICRO-CELL

112
MACRO TO MACRO
INTERCONNECTION

112
MACRO TO MACRO
INTERCONNECTION

121
ECL TO CMOS LEVEL
CONVERSION CIRCUIT

123
CMOS TO ECL LEVEL
CONVERSION CIRCUIT

121
ECL TO CMOS LEVEL
CONVERSION CIRCUIT

122
CMOS LOGIC
CIRCUIT

122
CMOS LOGIC
CIRCUIT

EP 0 473 144 A2

FIG. 4

# FIG.5

21b SMALL SIGNAL INTERCONNECTION

25b THROUGH-HOLE

21a SMALL SIGNAL INTERCONNECTION

22b LARGE SIGNAL INTERCONNECTION

25a THROUGH-HOLE

24e INSULATION FILM

24d INSULATION FILM

24c INSULATION FILM

22b LARGE SIGNAL INTERCONNECTION

24b INSULATION FILM

24a INSULATION FILM

23 SUBSTRATE

22a LARGE SIGNAL INTERCONNECTION

# FIG.6A

35a
THROUGH-HOLE

32b
LARGE SIGNAL
INTERCONNECTION

31
SMALL SIGNAL
INTERCONNECTION

32a
LARGE SIGNAL
INTERCONNECTION

36
37
35b
THROUGH-HOLE

31b

32a
LARGE SIGNAL
INTERCONNECTION

31a

35c
THROUGH-HOLE

VI

VI

31
SMALL SIGNAL
INTERCONNECTION

EP 0 473 144 A2

# FIG.6B

31
SMALL SIGNAL
INTERCONNECTION

32b
LARGE SIGNAL
INTERCONNECTION

35b
THROUGH-HOLE

36
SHIELDING
ELECTRODE

35a THROUGH-HOLE

32a
LARGE SIGNAL
INTERCONNECTION

34e INSULATION FILM
34d INSULATION FILM
34c INSULATION FILM
31a
34b INSULATION FILM
34a INSULATION FILM
33 SUBSTRATE

EP 0 473 144 A2

FIG.7

# FIG.8

# FIG.9

62b
LARGE SIGNAL
INTERCONNECTION

65
THROUGH-HOLE

61b
SMALL SIGNAL
INTERCONNECTION

62b

61a

61b 61b

61a
SMALL SIGNAL
INTERCONNECTION

65

65

61a

65 THROUGH-HOLE

65

65

62a
LARGE SIGNAL
INTERCONNECTION

62b

62a

65 THROUGH-HOLE

61b
SMALL SIGNAL
INTERCONNECTION

61b

62b
LARGE SIGNAL
INTERCONNECTION

EP 0 473 144 A2

# FIG.10

72b LARGE SIGNAL INTERCONNECTION

72b

75 THROUGH-HOLE

76a

76b POWER SOURCE LINE

71b

71b

71b SMALL SIGNAL INTERCONNECTION

76b

76b POWER SOURCE

75

71a SMALL SIGNAL INTERCONNECTION

75 THROUGH-HOLE

71a

76a POWER SOURCE LINE

75

72a LARGE SIGNAL INTERCONNECTION

75 THROUGH-HOLE

71b SMALL SIGNAL INTERCONNECTION

71b

75 THROUGH-HOLE

76b

72b LARGE SIGNAL INTERCONNECTION

EP 0 473 144 A2

EP 0 473 144 A2

# FIG.11A

81a
SMALL SIGNAL
INTERCONNECTION

82b
LARGE SIGNAL
INTERCONNECTION

81a 85 81a

87b
GROUND
LINE

85
THROUGH-HOLE

81b
SMALL SIGNAL
INTERCONNECTION

82b
LARGE SIGNAL
INTERCONNECTION

85

86a POWER SOURCE LINE

81b
SMALL SIGNAL
INTERCONNECTION

85
THROUGH-HOLE

86b POWER SOURCE LINE

85
THROUGH-HOLE

82a

82a
LARGE SIGNAL
INTERCONNECTION

## FIG.11B

81b
SMALL SIGNAL
INTERCONNECTION

81b
SMALL SIGNAL
INTERCONNECTION

87a
GROUND
LINE

85  81a

81a
SMALL SIGNAL
INTERCONNECTION

85
THROUGH-HOLE

81a

82b
LARGE SIGNAL
INTERCONNECTION

82a
LARGE SIGNAL
INTERCONNECTION

84e INSULATION FILM

84d INSULATION FILM

86a POWER SOURCE LINE

84c INSULATION FILM

84b INSULATION FILM

84a INSULATION FILM

83 SUBSTRATE

EP 0 473 144 A2

# FIG.12A

95b
THROUGH-HOLE

91b
SMALL SIGNAL
INTERCONNECTION

XII C

91a
SMALL SIGNAL
INTERCONNECTION

XII B

92a
SMALL SIGNAL
INTERCONNECTION

92b
SMALL SIGNAL
INTERCONNECTION

XII C

XII B

95a
THROUGH-HOLE

EP 0 473 144 A2

FIG. 12B

91a SMALL SIGNAL INTERCONNECTION
92a SMALL SIGNAL INTERCONNECTION
92b SMALL SIGNAL INTERCONNECTION

94e INSULATION FILM
94d INSULATION FILM
94c INSULATION FILM
94b INSULATION FILM
94a INSULATION FILM
93 SUBSTRATE
95a THROUGH-HOLE

## FIG. 12C

Labels: 95b THROUGH-HOLE; 91a SMALL SIGNAL INTERCONNECTION; 91b SMALL SIGNAL INTERCONNECTION; 92b SMALL SIGNAL INTERCONNECTION; 94e INSULATION FILM; 94d INSULATION FILM; 94c INSULATION FILM; 94b INSULATION FILM; 94a INSULATION FILM; 93 SUBSTRATE